# EUROPEAN PATENT SPECIFICATION

(11) **EP 3 051 646 B1**
(45) Date of publication and mention of the grant of the patent: **26.02.2020**
(21) Application number: 16152390.7
(22) Date of filing: 22.01.2016
(51) Int. Cl.: H02H 7/26, H01H 33/59, H03K 17/08, H02J 1/10, H02J 3/38, H03K 17/66, H02H 3/087, H02H 3/20

(54) **DIRECT CURRENT POWER SYSTEM**
GLEICHSTROMSYSTEM
SYSTÈME D'ALIMENTATION EN COURANT CONTINU

(30) Priority: 30.01.2015 US 201514609991
(43) Date of publication of application: 03.08.2016
(73) Proprietor: General Electric Company, Schenectady, NY 12345 (US)
(72) Inventor: TENCA, Pierluigi, Niskayuna, NY New York 12309 (US); SIHLER, Christof Martin, Niskayuna, NY New York 12309 (US)
(74) Representative: Serjeants LLP

(56) References cited:
- EP-A1- 0 489 945
- EP-A1- 2 634 885
- WO-A1-2011/141052
- US-A- 4 520 279
- US-A- 4 979 068

## Description

### BACKGROUND

The invention relates generally to power transmission and more specifically to a system and method for transmitting direct current electrical power to marine or subsea electrical equipment.

In the last few decades, the field of power conversion has grown tremendously due to its imminent advantages in motor drives, renewable energy systems, high voltage direct current (HVDC) systems, and the like. For example, a subsea oil and gas production system which requires hundreds of megawatts of electric power may employ a HVDC transmission and distribution system for delivery of electric power. Furthermore, in recent time, marine traffic has also increased substantially across the world due to tremendous rise in cargo transport vessels, warships, offshore oil ships, passenger ships etc. These vessels or ships have many electrical loads on board. Variable speed electric drives for pumps, fans, electric propulsion installations, lighting and air conditioning are some examples of the electrical loads on board of a ship.

Often subsea and marine power supply circuit arrangements include a direct current (DC) power system including a DC bus to which a plurality of power converters and a plurality of loads are connected. Power converters supply energy to the plurality of loads via the common DC bus. The common DC bus also includes a plurality of capacitors. Such a power system poses significant protection problems due to a large number of subsections in the circuit. In many cases, the common DC bus itself may be divided in a plurality of subsections and the relevant subsections then further form subsystems. The protection problems are exacerbated by the subsea environment and the customer requests of system availability for several years without maintenance. It is therefore necessary to design the overall set of subsystems connected to the common DC bus in a way that limits the damages when even just one of the subsystem fails because of a short-circuit fault. The main problem is discharge of large quantity of energy accumulated in the capacitors that are connected to the common DC bus from one subsystem to another.

One solution to mitigate above problem is the use of varistors in combination with RC snubbers which are devoted to absorb the energy associated with the DC bus current when a controllable switch opens during the fault. However, many of these solutions involve utilizing a DC circuit breaker.

Therefore, there still exists a need for a compact and a reliable system for transmitting electric power to subsea or marine equipment.

US 4979068 discloses a high speed electronic circuit breaker in the positive rail of a DC circuit that supplies a load.

### BRIEF DESCRIPTION

The present invention provides a direct current (DC) power system according to claim 1. The present invention further provides a method of supplying direct current (DC) power from one or more energy sources to one of more loads using a DC power system according to claim 9. Optional or non-essential features are defined in the dependent claims.

### DRAWINGS

FIG. 1 is a diagrammatical representation of a prior art DC power system for a marine or subsea equipment;
FIG. 2 is a schematic diagram illustrating a DC bus for use in a DC power system, in accordance with aspects of the present disclosure;
Fig. 3 is a graphical diagram illustrating simulation plots of the DC power system of Fig. 2, in accordance with an embodiment of the present technique; and
Fig 4 is a schematic diagram illustrating another DC power system, according to aspects of the present disclosure.

### DETAILED DESCRIPTION

Unless defined otherwise, technical and scientific terms used herein have the same meaning as is commonly understood by one of ordinary skill in the art to which this disclosure belongs. The terms "first", "second", and the like, as used herein do not denote any order, quantity, or importance, but rather are used to distinguish one element from another. Also, the terms "a" and "an" do not denote a limitation of quantity, but rather denote the presence of at least one of the referenced items. The term "or" is meant to be inclusive and mean one, some, or all of the listed items. The use of "including," "comprising" or "having" and variations thereof herein are meant to encompass the items listed thereafter and equivalents thereof as well as additional items. The terms "connected" and "coupled" are not restricted to physical or mechanical connections or couplings, and can include electrical connections or couplings, whether direct or indirect. Furthermore, the terms "circuit" and "circuitry" and "controller" may include either a single component or a plurality of components, which are either active and/or passive and are connected or otherwise coupled together to provide the described function.

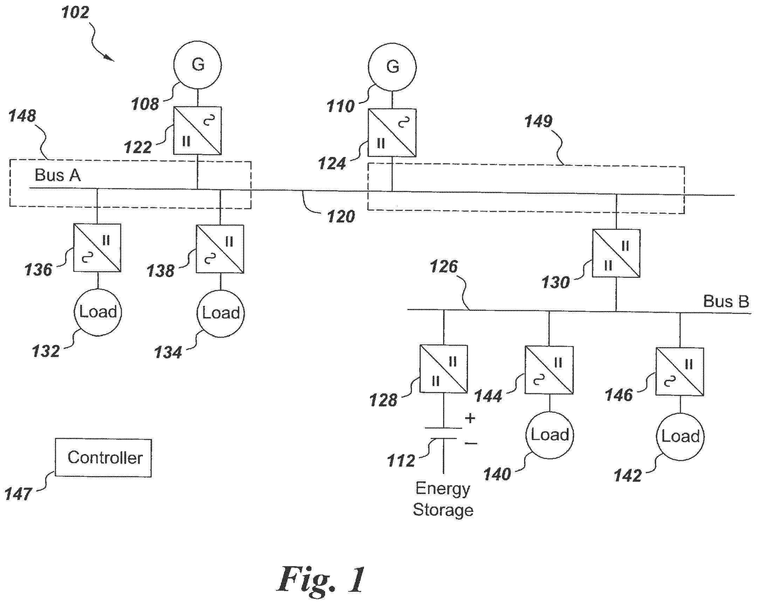

Turning now to the drawings, by way of example in FIG. 1, a prior art DC power system 102 for a marine or subsea equipment is depicted. The DC power system 102 includes energy sources such as alternating current (AC) generators 108, 110 which feed power to a DC bus 120 via power electronic converters 122 and 124 respectively. In one embodiment, for example for a subsea system, the DC power system 102 may receive energy from a power grid (not shown) via a transmission line (not shown). In the embodiment shown in FIG. 1, the DC power system 102 also includes an energy storage device 112 which feeds power to a DC bus 126 via a power electronic converter 128. The power electronic converters 122, 124 are AC/DC converters as they have to convert power from AC generators to the DC bus whereas power electronic converter 128 is a DC/DC converter as it couples a DC energy storage device to a DC bus. The two DC buses 120 and 126 do not have same DC voltage and hence are coupled to each other via a DC/DC converter 130. The DC/DC converter 130 may be a bidirectional DC/DC converter or a unidirectional DC/DC converter. Further, loads 132 and 134 are connected to DC bus 120 via power electronic converters 136 and 138 respectively, and loads 140 and 142 are connected to the DC bus 122 via power electronic converters 144 and 146 respectively. Depending on whether the load is an AC load or a DC load, the power electronic converter 136, 138, 144 and 146 may be AC/DC converters or DC/DC converters.

It should be noted that FIG. 1 is a single line diagram of DC power system 102. In other words, all converters have been shown to have only one input terminal and one output terminal for ease of explanation. However, a negative terminal or a reference terminal is always there at the input and the output of each of the converter. Similarly, DC bus 120 includes a positive rail and a negative rail (or ground rail) but for ease of explanation only one line is shown.

The DC power system 102 also includes a controller 147 to control the various AC/DC converters and/or DC/DC converters. Furthermore, the DC bus 120 includes two subsections 148 and 149. If there is a short circuit fault on subsection 148 then loads and generators connected to the other subsection 149 will also get affected. Similarly, if there a short circuit fault on subsection 149 then loads and generators connected to the other subsection 148 will get affected. Therefore, in accordance with an embodiment of the present technique, a DC bus separator is presented which isolates a faulty DC bus subsection from a healthy (or non-faulty) DC bus subsection and allows continuity of operation of the healthy DC bus subsection.

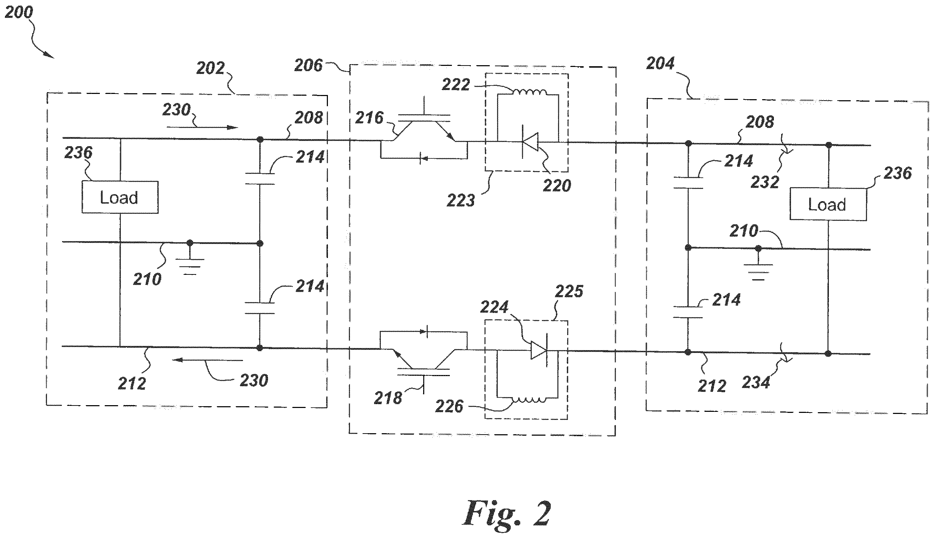

FIG. 2 illustrates a schematic diagram of a DC bus 200 for use in a DC power system in accordance with aspects of the present disclosure. The DC bus 200 includes a positive rail 208, a negative rail 212 and a ground rail 210. Furthermore, the DC bus 200 is split into two subsections 202 and 204. The subsection 202 and 204 are separated by a DC separator 206. The DC bus 200 also includes a plurality of capacitors 214 connected between the positive rail 208, the negative rail 212 and the ground rail 210. As discussed earlier, a plurality of loads 236 may be connected to the DC bus 200. The loads 236 shown in FIG. 2 are connected between the positive rail 208 and the negative rail 212. But other loads can be connected between the ground rail 210 and the negative rail 212 or between the positive rail 208 and the negative rail 212.

The DC bus 200 shown in FIG. 2 allows controlled separation of the DC bus subsections 202, 204 when the DC power flow is unidirectional i.e., a DC power transfer from subsection 202 to subsection 204. However, the technique disclosed here is also applicable for a DC bus structure where controlled separation must be provided also with bidirectional power flow, i.e. a DC power transfer between subsection 202 and subsection 204 in both directions. When there is a short circuit fault on subsection 204, for example, the DC bus separator 206 isolates the faulty subsection 204 from the healthy subsection 202. In other words, when the fault occurs, the DC bus separator 206 blocks a DC bus current 230 flowing from the healthy subsection 202 to the faulty subsection 204.

The DC bus separator 206 includes a positive rail controllable switch 216 in its positive rail 208 and a negative rail controllable switch 218 in its negative rail 212. The DC bus separator 206 further includes a positive rail diode-inductor pair 223 in its positive rail 208 and a negative rail diode-inductor pair 225 in its negative rail 212. The positive rail diode-inductor pair 223 includes a positive rail diode 220 connected in parallel with a positive rail inductor 222. The positive rail diode-inductor pair 223 is then further connected to the positive rail controllable switch 216. In particular, the positive rail controllable switch 216 is connected in series with the positive rail inductor 222 and a current path is provided between the subsections 202, 204 during normal operation via the controllable switch 216 and the inductor 222. It should be noted here that the term 'series connection' refers to a physical and/or electrical connection between two elements i.e., they are connected one after another and one of the terminals of each element is coupled together. Furthermore, the positive rail controllable switch 216 is controlled to be switched off to break the current path when a fault is detected on a DC bus subsection. In the embodiment shown, the anode of the positive rail diode 220 is coupled to the subsection 204 and the cathode is connected to the controllable switch 216. The positive rail diode 220 connected in parallel to the positive rail inductor 222 provides a circulating current path to dissipate an inductor current in the positive rail inductor 222 when the positive rail controllable switch 216 is not conducting or is switched off due to a fault.

Similarly, the negative rail diode-inductor pair 225 includes a negative rail diode 224 connected in parallel with a negative rail inductor 226. In the embodiment shown, the cathode of the negative rail diode 224 is connected to the negative rail controllable switch 218 and the anode is connected to the subsection 204. A current path is provided between the subsections 202, 204 during normal operation via the negative rail controllable switch 218 and the negative rail inductor 226. Furthermore, the negative rail controllable switch 218 is controlled to be switched off to break the current path when a fault is detected on a DC bus substation. The negative rail diode 224 connected in parallel to the negative rail inductor 226 provides a circulating current path to dissipate an inductor current in the negative rail inductor 226 when the negative rail controllable switch 218 is not conducting or is switched off due to a fault.

The controllable switches such as switches 216 and 218 may include switching devices based on semiconductor technology, such as an insulated gate bipolar transistor (IGBT), a metal oxide semiconductor field effect transistor (MOSFET), a field effect transistor (FET), a gate turn-off thyristor, an insulated gate commutated thyristor (IGCT), an injection enhanced gate transistor (IEGT), a silicon carbide based switch, a gallium nitride based switch, a gallium arsenide based switch, or equivalents thereof. Furthermore, the controllable switches may include a plurality of switching devices connected in series or in parallel or combinations thereof.

As discussed above, the DC bus 200 allows controlled separation when the DC power flow is unidirectional. Therefore, during normal operation, DC power flows from subsection 202 to subsection 204. The controllable switches 216 and 218 are switched on during normal operation and a DC bus current 230 flows in the positive rail 208 from subsection 202 to subsection 204 through the positive rail controllable switch 216 and the positive rail inductor 222. Furthermore, the DC bus current 230 in the negative rail 212 flows from subsection 204 to subsection 202 through the negative rail inductor 226 and the negative rail controllable switch 218. The diodes 220 and 224 are reverse biased because the DC bus current 230 cannot flow in them when it is positive as indicated in FIG. 2.

When a short circuit fault 232 occurs on positive rail 208 in subsection 204, for example, the DC bus current 230 begins to rise substantially and the inductors 222 and 226 generate increased negative voltage across the diodes 220 and 224. This results in the positive rail diode 220 becoming even more reverse biased. Once the short circuit current or fault current is detected by a sensor (not shown), the controller 147 (FIG. 1) switches off the positive rail controllable switch 216 and isolates the positive rail 208 of the healthy (or non-faulty) subsection 202 from the positive rail 208 of the faulty subsection 204. In one embodiment, the inductor 222 is designed to limit the current rate of increase in the controllable switch 216 so that even after the unavoidable delay caused by sensing and protection, the controllable switch 216 can still be switched off safely i.e., at below its maximum commutable current. Once the controllable switch 216 is switched off, the current in the inductor 222 starts decreasing which immediately generates forward voltage across the diode 220 and the current then flows through the diode 220 i.e., the diode 220 acts as a freewheeling diode for the inductor current. Since the diode 220 starts conducting, any antiparallel diode across the controllable switch 216 does not conduct. Furthermore, since the inductor current receives a current path via the diode 220, no significant overvoltage is generated across the controllable switch 216 and also the controllable switch 216 does not need large energy absorbers in parallel to it. The inductor current eventually extinguishes and the diode 220 becomes reverse biased again, thereby assuring indefinite separation of the positive rail 208 of the healthy subsection 202 from the faulty subsection 204 and thus, continuity of operation of subsection 202. It should be noted that even though the positive rails 208 of the subsections 202, 204 have been separated by the DC bus separator 206, the negative rails 212 of the subsections 202, 204 are still coupled. Furthermore, any loads connected between the negative rail 212 and the positive rail 210 of the subsection 204 may still be operative at reduced voltage since the positive rail voltage drops to ground rail voltage because of the short circuit.

If a short circuit fault 234 also occurs on the negative rail 212 of subsection 204, at first the negative rail diode 224 becomes even more reverse biased and then once the negative rail controllable switch 218 is switched off, the negative rail diode 224 becomes forward biased and provides a freewheeling path for the inductor current of the negative rail inductor 226. This separates the negative rails 212 of the subsections 202, 204. Eventually the inductor current extinguishes and the healthy subsection 202 continues to operate normally.

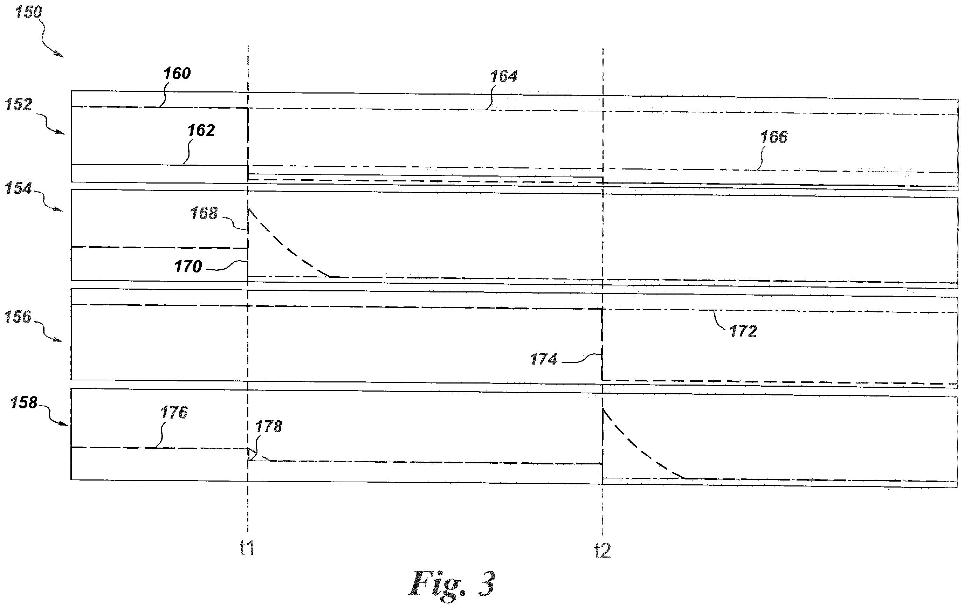

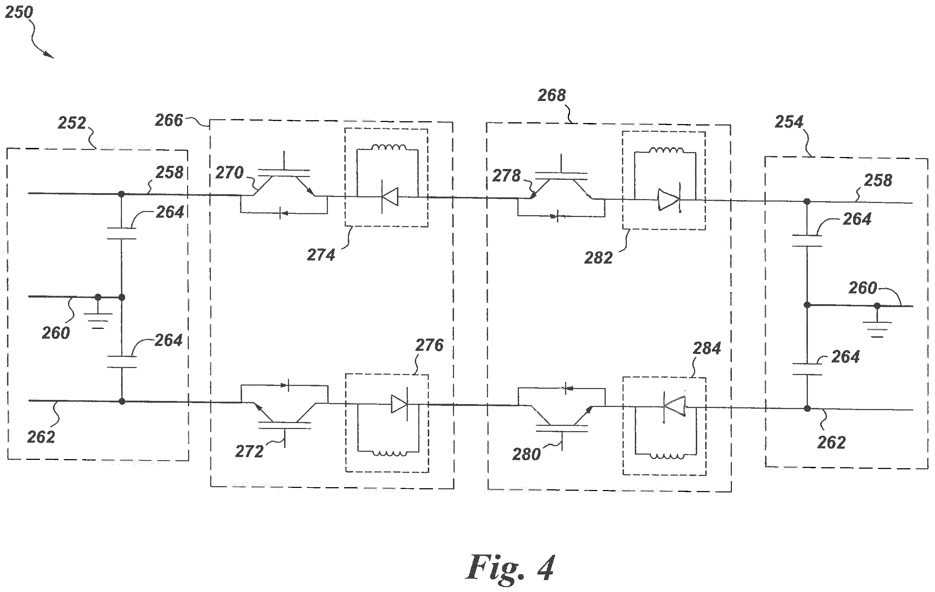

Referring now to FIG. 3, a graphical diagram 150 illustrating simulation plots of the DC power system of FIG. 2 in accordance with an embodiment of the present technique are depicted. The plots shown are for simulated short circuit faults on the positive rail 208 of subsection 204 at time t1 and on the negative rail 212 of subsection 204 at time t2. In FIG. 4, plot 152 shows four signals, namely a positive rail voltage signal 160 of the faulty subsection 204, a load current signal 162 of the faulty subsection 204, a positive rail voltage signal 164 of the healthy subsection 202, and a load current signal 166 of the healthy subsection 202. As can be seen from plot 152, when the first short circuit fault occurs at time t1, the positive rail voltage signal 160 drops to zero and therefore the load current signal 162 of the faulty subsection 204 also drops to half of its original current value. The load current signal 162 further reduces to zero at time t2 when the second short circuit occurs and the negative rail voltage also becomes zero because of the fault. Also it can be noted that since the healthy subsection 202 is isolated, the positive rail voltage signal 164 and the load current signal 166 of the healthy subsection 202 do not see any change and it continues to operate normally.

Plot 154 in FIG. 3 shows two currents signals, namely an inductor current signal 168 of the positive rail inductor 222 and a positive rail current signal 170 of the faulty subsection 204. As can be seen, the positive rail current signal 170 reduces to zero at time t1 when the short circuit fault occurs on the positive rail 208 of subsection 204. Furthermore, there is a slight spike in the inductor current signal 168 at time t1. After time t1, the inductor current signal 168 starts recirculating via positive rail diode 220 and after a while it completely extinguishes.

Plot 156 in FIG. 3 shows a negative rail voltage signal 172 of the healthy subsection 202 and a negative rail voltage signal 174 of the faulty subsection 204. The first fault at time t1 does not affect either of the voltage signals 172 and 174. However, the second short circuit fault which occurs on the negative rail 212 of subsection 204 at time t2 affects the negative rail voltage signal 174 which reduces to zero at time t2. Furthermore, plot 158 of FIG. 3 shows an inductor current signal 176 of the negative rail inductor 226 and a negative rail current 178 on the faulty subsection 204. At time t1, the inductor current signal 176 as well as the negative rail current 178 both reduce to half their original value. Furthermore, at time t2, both the inductor current signal 176 and the negative rail current 178 reduce to zero value. It can be noted that as expected the inductor current signal 176 does not reduce to half or zero value immediately at times t1 and t2 respectively, rather it takes a short time before going to zero value. At time t2, the subsections 202, 204 are completely isolated.

FIG. 4 illustrates a schematic diagram of another DC bus 250 for use in a DC power system in accordance with aspects of the present disclosure. The DC bus 250 includes a DC bus subsection 252 and a DC bus subsection 254. The DC bus 250 allows bidirectional power flow i.e., the DC power can flow from subsection 252 to subsection 254 or from subsection 254 to subsection 252 as required. The DC bus 250 also includes a positive rail 258, a ground rail 260 and a negative rail 262. A plurality of capacitors 264 and loads (not shown) may be connected between the positive rail 258, the ground rail 260 and the negative rail 262. Since the DC bus 250 allows bidirectional power flow, two DC bus separators 266, 268 are used in the embodiment of FIG. 4. The DC power system includes at least two DC bus separators 266, 268, each configured to isolate the healthy subsection from the faulty subsection depending on the direction of the DC bus current.

A first DC bus separator 266 and a second DC bus separator 268 are connected in series in opposite polarity. It should be noted that two DC bus separators 266, 268 are used in this embodiment as the DC power may flow from subsection 252 to subsection 254 or *vice versa.* Furthermore, the reason for connecting the two DC bus separators 266, 268 in opposite polarity is that the DC bus current can flow in either direction. Thus, either DC bus separator 266 or DC bus separator 268 may work to protect the system depending on the direction of the DC bus current.

Similar to the DC bus separator 206 described with reference to FIG. 2, the first and second DC bus separators 266, 268 include a controllable switch and a diode-inductor pair in its positive and negative rails 258, 262. For example, the first DC bus separator 266 includes controllable switches 270 and 272 and diode-inductor pairs 274, 276 in its positive rail 258 and its negative rail 262 respectively. Similarly, the second DC bus separator 268 includes controllable switches 278 and 280 and diode-inductor pairs 282, 284 in its positive rail 258 and its negative rail 262 respectively. The DC bus separators 266, 268 operate in a similar manner to the DC bus separator 206 of FIG. 2. But the first DC bus separator 266 protects the subsection 252 in case of a fault on the subsection 254 and the second DC bus separator 268 protects the subsection 254 in case of a fault on the subsection 252. In the embodiment shown, the anode of the positive rail diode of the first DC bus separator 266 is coupled to the controllable switch 278 of the second DC bus separator 268 and the cathode is connected to the controllable switch 270. The cathode of the negative rail diode of the first DC bus separator 266 is connected to the controllable switch 280 of the second DC bus separator and the anode is connected to the controllable switch 272. The anode of the positive rail diode of the second DC bus separator 268 is connected to the controllable switch 278 and the cathode is connected to the subsection 254. The cathode of the negative rail diode of the second DC bus separate 268 is connected to the controllable switch 280 and the anode is connected to the subsection 254.

As an example, for a case where DC power is flowing from the subsection 254 to the subsection 252, during normal operation all of the controllable switches 270, 272, 278 and 280 are conducting and the DC current flows through the inductors of the diode-inductor pairs 282 and 284, controllable switches 270, 272, 278, 280, and the diodes of diode-inductor pair 274, 276. If there is a fault on the positive rail 258 of subsection 252, at first the diode of the diode-inductor pair 282 becomes even more reverse biased and then once the controllable switch 278 is switched off, the diode of the diode-inductor pair 282 becomes forward biased and provides a freewheeling path for the inductor current of the inductor of the diode-inductor pair 282. Eventually the inductor current extinguishes and the second DC bus separator 268 isolates the positive rail 258 of the healthy subsection 254 from the positive rail 258 of the faulty subsection 252. If there is a fault on the positive rail 258 of subsection 254, the first DC bus separator 266 would isolate the positive rail 258 of the healthy subsection 252 from the positive rail 258 of the faulty subsection 254 in a similar manner. The first and second DC bus separators 266, 268 will also isolate the negative rail of a healthy subsection from the negative rail of a faulty subsection in a similar manner.

One of the advantages of the present system is high system availability via a more fault tolerant conversion structure based on splitting of the DC link of power converters. The system provides a simple arrangement without varistors for isolation between two subsections of the DC common DC bus.

While only certain features of the invention have been illustrated and described herein, many modifications and changes will occur to those skilled in the art. It is, therefore, to be understood that the appended claims define the invention.

## Claims

1. A direct current (DC) power system comprising:
a common DC bus (200; 250) having at least one positive rail (208; 258) and at least one negative rail (212; 262), the common DC bus (200; 250) coupled between one or more energy sources and one or more loads, wherein the common DC bus (200; 250) comprises:
two DC bus subsections (202, 204; 252, 254);
at least one DC bus separator (206; 266, 268) coupled between the two DC bus subsections (202, 204; 252, 254);
wherein each DC bus separator (206; 266, 268) comprises:
at least one positive rail controllable switch (216; 270, 278) connected in series to a positive rail inductor (222), the series-connected at least one positive rail controllable switch (216; 270, 278) and positive rail inductor (222) providing a positive current path between the two DC bus subsections (202, 204; 252, 254) during normal operation of the DC power system, wherein the at least one positive rail controllable switch (216; 270, 278) is controlled to be switched off to break the positive current path when a fault on the positive rail (208; 258) is detected;
a positive rail diode (220) connected in parallel with the positive rail inductor (222), the positive rail diode (220) having a conducting direction opposite the conducting direction of the at least one positive rail controllable switch (216; 270, 278) and providing a circulating current path to dissipate an inductor current in the positive rail inductor (222) when the at least one positive rail controllable switch (216; 270, 278) is switched off;
**characterised in that** each DC bus separator (206; 266, 268) further comprises:
at least one negative rail controllable switch (218; 272, 280) connected in series to a negative rail inductor (226), the series-connected at least one negative rail controllable switch (218; 272, 280) and negative rail inductor (226) providing a negative current path between the two DC bus subsections (202, 204; 252, 254) during normal operation of the DC power system, wherein the negative rail controllable switch (218; 272, 280) is controlled to be switched off to break the negative current path when a fault on the negative rail (212; 262) is detected; and
a negative rail diode (224) connected in parallel with the negative rail inductor (226), the negative rail diode (224) having a conducting direction opposite the conducting direction of the at least one negative rail controllable switch (218; 270, 278) and providing a circulating current path to dissipate an inductor current in the negative rail inductor (226) when the at least one negative rail controllable switch (218; 272, 280) is switched off.

2. A DC power system according to claim 1, wherein the positive rail controllable switch comprises a plurality of switching devices connected in series or in parallel or combinations thereof.

3. A DC power system according to claim 1 or claim 2, wherein the common DC bus (200; 250) is configured for unidirectional power flow or bidirectional power flow.

4. A DC power system according to any preceding claim, wherein the common DC bus (250) is configured for bidirectional power flow, and wherein the DC power system further comprises at least two DC bus separators (266, 268) connected in series with opposite polarity, each DC bus separator (266, 268) configured to isolate the healthy DC bus subsection from the faulty DC bus subsection depending on the direction of the DC bus current when a fault is detected.

5. A DC power system according to any preceding claim, wherein a plurality of DC capacitors (214; 264) are connected between the positive rail and the negative rail of the common DC bus (200; 250).

6. A DC power system according to any preceding claim, further comprising a plurality of loads (236), optionally being marine or subsea equipment, connected between the positive rail and the negative rail of the common DC bus (200; 250).

7. A DC power system according to any preceding claim, wherein the common DC bus (200; 250) further includes a ground rail (260), and wherein a plurality of DC capacitors (214; 264) are connected between the ground rail and the positive rail or between the ground rail and the negative rail of the common DC bus (200; 250).

8. A DC power system according to claim 7, further comprising a plurality of loads (236), optionally being marine or subsea equipment, connected between the ground rail and the positive rail or between the ground rail and the negative rail of the common DC bus (200; 250).

9. A method of supplying direct current (DC) power from one or more energy sources to one of more loads using a DC power system comprising a common DC bus (200; 250) having at least one positive rail (208; 258) and at least one negative rail (212; 262), wherein the common DC bus (200; 250) comprises:
two DC bus subsections (202, 204; 252, 254); and
at least one DC bus separator (206; 266, 268) coupled between the two DC bus subsections (202, 204; 252, 254);
wherein each DC bus separator (206; 266, 268) comprises:
at least one positive rail controllable switch (216; 270, 278) connnected is series to a positive rail inductor (222), the series-connected at least one positive rail controllable switch (216; 270, 278) and positive rail inductor (222) providing a positive current path between the two DC bus subsections (202, 204; 252, 254) during normal operation of the DC power system;
a positive rail diode (220) connected in parallel with the positive rail inductor (222), the positive rail diode (220) having a conducting direction opposite the conducting direction of the at least one positive rail controllable switch (216; 270, 278) and providing a circulating current path;
at least one negative rail controllable switch (218; 272, 280) connected in series to a negative rail inductor (226), the series-connected at least one negative rail controllable switch (218; 272, 280) and negative rail inductor (226) providing a negative current path between the two DC bus subsections (202, 204; 252, 254) during normal operation of the DC power system; and
a negative rail diode (224) connected in parallel with the negative rail inductor (226), the negative rail diode (224) having a conducting direction opposite the conducting direction of the at least one negative rail controllable switch (218; 270, 278) and providing a circulating current path;
the method comprising the steps of:
when a fault on the positive rail (208; 258) is detected, controlling the at least one positive rail controllable switch (216; 270, 278) to be switched off to break the positive current path, wherein the circulating circuit path provided by the positive rail diode (220) dissipates an inductor current in the positive rail inductor (222) when the at least one positive rail controllable switch (216; 270, 278) is switched off; and
when a fault on the negative rail (212; 262) is detected, controlling the at least one negative rail controllable switch (218; 272, 280) to be switched off to break the negative current path, wherein the circulating current path provided by the negative rail diode (224) dissipates an inductor current in the negative rail inductor (226) when the at least one negative rail controllable switch (218; 272, 280) is switched off.

10. A method according to claim 9, wherein the common DC bus (250) is configured for bidirectional power flow, and wherein the DC power system further comprises at least two DC bus separators (266, 268) connected in series with opposite polarity, each DC bus separator (266, 268) configured to isolate the healthy DC bus subsection from the faulty DC bus subsection depending on the direction of the DC bus current when a fault is detected.

11. A method according to claim 9 or claim 10, wherein the common DC bus (200; 250) further includes a ground rail (260), and wherein a plurality of DC capacitors (214; 264) is connected between the positive rail and the negative rail or between the ground rail and the positive rail or between the ground rail and the negative rail of the common DC bus.

12. A method according to claim 11, wherein the one or more loads (236) are connected between the positive rail and the negative rail or between the positive rail and the ground rail or between the negative rail and the ground rail.

13. A method according to any of claims 9 to 12, wherein providing DC power to the one or more loads (236) comprises providing DC power to marine or subsea equipment.

14. A method according to any of claims 9 to 13, wherein the at least one positive rail controllable switch is controlled to be switched off by a controller (147).

## Patentansprüche

1. Gleichstrom- (DC) -system, umfassend:
einen gemeinsamen Gleichstrombus (200; 250), der zumindest eine positive Schiene (208; 258) und zumindest eine negative Schiene (212; 262) aufweist, wobei der gemeinsame Gleichstrombus (200; 250) zwischen einer oder mehreren Energiequellen und einer oder mehreren Lasten gekoppelt ist, wobei der gemeinsame Gleichstrombus (200; 250) umfasst:
zwei Gleichstrombusuntersektionen (202, 204; 252, 254);
zumindest einen Gleichstrombusseparator (206; 266, 268), der zwischen den zwei Gleichstrombusuntersektionen (202, 204; 252, 254) gekoppelt ist;
wobei jeder Gleichstrombusseparator (206; 266, 268) umfasst:
zumindest einen steuerbaren Schalter (216; 270, 278) der positiven Schiene, der in Reihe mit einer Spule (222) der positiven Schiene verbunden ist, wobei der in Reihe verbundene zumindest eine steuerbare Schalter (216; 270, 278) der positiven Schiene und die Spule (222) der positiven Schiene einen positiven Stromweg zwischen den zwei Gleichstrombusuntersektionen (202, 204; 252, 254) während normalen Betriebs des Gleichstromsystems bereitstellen, wobei der zumindest eine steuerbare Schalter (216; 270, 278) der positiven Schiene gesteuert wird, ausgeschaltet zu werden, um den positiven Stromweg zu unterbrechen, wenn eine Störung an der positiven Schiene (208; 258) detektiert wird;
eine Diode (220) der positiven Schiene, die parallel mit der Spule (222) der positiven Schiene verbunden ist, wobei die Diode (220) der positiven Schiene eine Leitrichtung entgegen der Leitrichtung des zumindest einen steuerbaren Schalters (216; 270, 278) der positiven Schiene aufweist und einen zirkulierenden Stromweg bereitstellt, um einen Spulenstrom in der Spule (222) der positiven Schiene abzuführen, wenn der zumindest eine steuerbare Schalter (216; 270, 278) der positiven Schiene ausgeschaltet ist;
**dadurch gekennzeichnet, dass** jeder Gleichstrombusseparator (206; 266, 268) weiter umfasst:
zumindest einen steuerbaren Schalter (218; 272, 280) der negativen Schiene, der in Reihe mit einer Spule (226) der negativen Schiene verbunden ist, wobei der in Reihe verbundene zumindest eine steuerbare Schalter (218; 272, 280) der negativen Schiene und die Spule (226) der negativen Schiene einen negativen Stromweg zwischen den zwei Gleichstrombusuntersektionen (202, 204; 252, 254) während normalen Betriebs des Gleichstromsystems bereitstellen, wobei der steuerbare Schalter (218; 272, 280) der negativen Schiene gesteuert wird, ausgeschaltet zu werden, um den negativen Stromweg zu unterbrechen, wenn eine Störung an der negativen Schiene (212; 262) detektiert wird; und
eine Diode (224) der negativen Schiene, die parallel mit der Spule (226) der negativen Schiene verbunden ist, wobei die Diode (224) der negativen Schiene eine Leitrichtung entgegen der Leitrichtung des zumindest einen steuerbaren Schalters (218; 270, 278) der negativen Schiene aufweist und einen zirkulierenden Stromweg bereitstellt, um einen Spulenstrom in der Spule (226) der negativen Schiene abzuführen, wenn der zumindest eine steuerbare Schalter (218; 272, 280) der negativen Schiene ausgeschaltet ist.

2. Gleichstromsystem nach Anspruch 1, wobei der steuerbare Schalter der positiven Schiene eine Vielzahl von Schaltvorrichtungen, die in Reihe oder parallel verbunden sind, oder Kombinationen davon umfasst.

3. Gleichstromsystem nach Anspruch 1 oder Anspruch 2, wobei der gemeinsame Gleichstrombus (200; 250) für unidirektionalen Stromfluss oder bidirektionalen Stromfluss gestaltet ist.

4. Gleichstromsystem nach einem der vorstehenden Ansprüche, wobei der gemeinsame Gleichstrombus (250) für bidirektionalen Stromfluss gestaltet ist und wobei das Gleichstromsystem weiter zumindest zwei Gleichstrombusseparatoren (266, 268) umfasst, die in Reihe mit entgegengesetzter Polarität verbunden sind, wobei jeder Gleichstrombusseparator (266, 268) gestaltet ist, die gesunde Gleichstrombusuntersektion von der gestörten Gleichstrombusuntersektion zu isolieren, abhängig von der Richtung des Gleichstrombusstroms, wenn eine Störung detektiert wird.

5. Gleichstromsystem nach einem der vorstehenden Ansprüche, wobei eine Vielzahl von Gleichstromkondensatoren (214; 264) zwischen der positiven Schiene und der negativen Schiene des gemeinsamen Gleichstrombusses (200; 250) verbunden sind.

6. Gleichstromsystem nach einem der vorstehenden Ansprüche, weiter umfassend eine Vielzahl von Lasten (236), optional Marine- oder Unterwasserausrüstung, die zwischen der positiven Schiene und der negativen Schiene des gemeinsamen Gleichstrombusses (200; 250) verbunden sind.

7. Gleichstromsystem nach einem der vorstehenden Ansprüche, wobei der gemeinsame Gleichstrombus (200; 250) weiter eine Masseschiene (260) beinhaltet und wobei eine Vielzahl von Gleichstromkondensatoren (214; 264) zwischen der Masseschiene und der positiven Schiene oder zwischen der Masseschiene und der negativen Schiene des gemeinsamen Gleichstrombusses (200; 250) verbunden sind.

8. Gleichstromsystem nach Anspruch 7, weiter umfassend eine Vielzahl von Lasten (236), optional Marine- oder Unterwasserausrüstung, die zwischen der Masseschiene und der positiven Schiene oder zwischen der Masseschiene und der negativen Schiene des gemeinsamen Gleichstrombusses (200; 250) verbunden sind.

9. Zufuhrverfahren von Gleichstrom (DC) von einer oder mehreren Energiequellen an eine von mehreren Lasten unter Verwendung eines Gleichstromsystems, das einen gemeinsamen Gleichstrombus (200; 250) umfasst, der zumindest eine positive Schiene (208; 258) und zumindest eine negative Schiene (212; 262) aufweist, wobei der gemeinsame Gleichstrombus (200; 250) umfasst:
zwei Gleichstrombusuntersektionen (202, 204; 252, 254); und
zumindest einen Gleichstrombusseparator (206; 266, 268), der zwischen den zwei Gleichstrombusuntersektionen (202, 204; 252, 254) gekoppelt ist;
wobei jeder Gleichstrombusseparator (206; 266, 268) umfasst:
zumindest einen steuerbaren Schalter (216; 270, 278) der positiven Schiene, der in Reihe mit einer Spule (222) der positiven Schiene verbunden ist, wobei der in Reihe verbundene zumindest eine steuerbare Schalter (216; 270, 278) der positiven Schiene und die Spule (222) der positiven Schiene einen positiven Stromweg zwischen den zwei Gleichstrombusuntersektionen (202, 204; 252, 254) während normalen Betriebs des Gleichstromsystems bereitstellen;
eine Diode (220) der positiven Schiene, die parallel mit der Spule (222) der positiven Schiene verbunden ist, wobei die Diode (220) der positiven Schiene eine Leitrichtung entgegen der Leitrichtung des zumindest einen steuerbaren Schalters (216; 270, 278) der positiven Schiene aufweist und einen zirkulierenden Stromweg bereitstellt;
zumindest einen steuerbaren Schalter (218; 272, 280) der negativen Schiene, der in Reihe mit einer Spule (226) der negativen Schiene verbunden ist, wobei der in Reihe verbundene zumindest eine steuerbare Schalter (218; 272, 280) der negativen Schiene und die Spule (226) der negativen Schiene einen negativen Stromweg zwischen den zwei Gleichstrombusuntersektionen (202, 204; 252, 254) während normalen Betriebs des Gleichstromsystems bereitstellen; und
eine Diode (224) der negativen Schiene, die parallel mit der Spule (226) der negativen Schiene verbunden ist, wobei die Diode (224) der negativen Schiene eine Leitrichtung entgegen der Leitrichtung des zumindest einen steuerbaren Schalters (218; 270, 278) der negativen Schiene aufweist und einen zirkulierenden Stromweg bereitstellt;
das Verfahren umfassend die Schritte zum:
wenn eine Störung an der positiven Schiene (208; 258) detektiert wird, Steuern des zumindest einen steuerbaren Schalters (216; 270, 278) der positiven Schiene, ausgeschaltet zu werden, um den positiven Stromweg zu unterbrechen, wobei der zirkulierende Stromweg, der von der Diode (220) der positiven Schiene bereitgestellt ist, einen Spulenstrom in der Spule (222) der positiven Schiene abführt, wenn der zumindest eine steuerbare Schalter (216; 270, 278) der positiven Schiene ausgeschaltet ist; und
wenn eine Störung an der negativen Schiene (212; 262) detektiert wird, Steuern des zumindest einen steuerbaren Schalters (218; 272, 280) der negativen Schiene, ausgeschaltet zu werden, um den negativen Stromweg zu unterbrechen, wobei der zirkulierende Stromweg, der von der Diode (224) der negativen Schiene bereitgestellt ist, einen Spulenstrom in der Spule (226) der negativen Schiene abführt, wenn der zumindest eine steuerbare Schalter (218; 272, 280) der negativen Schiene ausgeschaltet ist.

10. Verfahren nach Anspruch 9, wobei der gemeinsame Gleichstrombus (250) für bidirektionalen Stromfluss gestaltet ist und wobei das Gleichstromsystem weiter zumindest zwei Gleichstrombusseparatoren (266, 268) umfasst, die in Reihe mit entgegengesetzter Polarität verbunden sind, wobei jeder Gleichstrombusseparator (266, 268) gestaltet ist, die gesunde Gleichstrombusuntersektion von der gestörten Gleichstrombusuntersektion zu isolieren, abhängig von der Richtung des Gleichstrombusstroms, wenn eine Störung detektiert wird.

11. Verfahren nach Anspruch 9 oder Anspruch 10, wobei der gemeinsame Gleichstrombus (200; 250) weiter eine Masseschiene (260) beinhaltet und wobei eine Vielzahl von Gleichstromkondensatoren (214; 264) zwischen der positiven Schiene und der negativen Schiene oder zwischen der Masseschiene und der positiven Schiene oder zwischen der Masseschiene und der negativen Schiene des gemeinsamen Gleichstrombusses verbunden ist.

12. Verfahren nach Anspruch 11, wobei die eine oder mehreren Lasten (236) zwischen der positiven Schiene und der negativen Schiene oder zwischen der positiven Schiene und der Masseschiene oder zwischen der negativen Schiene und der Masseschiene verbunden sind.

13. Verfahren nach einem der Ansprüche 9 bis 12, wobei Bereitstellen des Gleichstroms an eine oder mehrere Lasten (236) Bereitstellen von Gleichstrom an Marine-oder Unterwasserausrüstung umfasst.

14. Verfahren nach einem der Ansprüche 9 bis 13, wobei der zumindest eine steuerbare Schalter der positiven Schiene gesteuert wird, von einer Steuerung (147) ausgeschaltet zu werden.

## Revendications

1. Système d'alimentation en courant continu (CC) comprenant :
un bus CC commun (200; 250) présentant au moins un rail positif (208 ; 258) et au moins un rail négatif (212; 262), le bus CC commun (200; 250) couplé entre une ou plusieurs sources d'énergie et une ou plusieurs charges, dans lequel le bus CC commun (200; 250) comprend :
deux sous-sections de bus CC (202, 204 ; 252, 254) ;
au moins un séparateur de bus CC (206 ; 266, 268) couplé entre les deux sous-sections de bus CC (202, 204 ; 252, 254) ;
dans lequel chaque séparateur de bus CC (206 ; 266, 268) comprend :
au moins un commutateur pouvant être commandé de rail positif (216 ; 270, 278) connecté en série à un inducteur de rail positif (222), l'au moins un commutateur pouvant être commandé de rail positif connecté en série (216 ; 270, 278) et l'inducteur de rail positif (222) fournissant un trajet de courant positif entre les deux sous-sections de bus CC (202, 204 ; 252, 254) pendant le fonctionnement normal du système d'alimentation CC, dans lequel l'au moins un commutateur pouvant être commandé de rail positif (216 ; 270, 278) est commandé pour être éteint afin de couper le trajet de courant positif lorsqu'une défaillance sur le rail positif (208 ; 258) est détectée ;
une diode de rail positif (220) connectée en parallèle à l'inducteur de rail positif (222), la diode de rail positif (220) présentant une direction de conduction opposée à la direction de conduction de l'au moins un commutateur pouvant être commandé de rail positif (216 ; 270, 278) et fournissant un trajet de courant de circulation pour dissiper un courant d'inducteur dans l'inducteur de rail positif (222) lorsque l'au moins un commutateur pouvant être commandé de rail positif (216 ; 270, 278) est éteint ;
**caractérisé en ce que** chaque séparateur de bus CC (206 ; 266, 268) comprend en outre :
au moins un commutateur pouvant être commandé de rail négatif (218 ; 272, 280) connecté en série à un inducteur de rail négatif (226), l'au moins un commutateur pouvant être commandé de rail négatif connecté en série (218 ; 272, 280) et l'inducteur de rail négatif (226) fournissant un trajet de courant négatif entre les deux sous-sections de bus CC (202, 204 ; 252, 254) pendant le fonctionnement normal du système d'alimentation CC, dans lequel le commutateur pouvant être commandé de rail négatif (218 ; 272, 280) est commandé pour être éteint afin de couper le trajet de courant négatif lorsqu'une défaillance sur le rail négatif (212 ; 262) est détectée ; et
une diode de rail négatif (224) connectée en parallèle à l'inducteur de rail négatif (226), la diode de rail négatif (224) présentant une direction de conduction opposée à la direction de conduction de l'au moins un commutateur pouvant être commandé de rail négatif (218; 270, 278) et fournissant un trajet de courant de circulation pour dissiper un courant d'inducteur dans l'inducteur de rail négatif (226) lorsque l'au moins un commutateur pouvant être commandé de rail négatif (218 ; 272, 280) est éteint.

2. Système d'alimentation CC selon la revendication 1, dans lequel le commutateur pouvant être commandé de rail positif comprend une pluralité de dispositifs de commutation connectés en série ou en parallèle ou des combinaisons de ceux-ci.

3. Système d'alimentation CC selon la revendication 1 ou la revendication 2, dans lequel le bus CC commun (200; 250) est configuré pour un flux de puissance unidirectionnel ou un flux de puissance bidirectionnel.

4. Système d'alimentation CC selon l'une quelconque des revendications précédentes, dans lequel le bus CC commun (250) est configuré pour un flux de puissance bidirectionnel, et dans lequel le système d'alimentation CC comprend en outre au moins deux séparateurs de bus CC (266, 268) connectés en série de polarité opposée, chaque séparateur de bus CC (266, 268) configuré pour isoler la sous-section de bus CC saine de la sous-section de bus CC défaillante en fonction de la direction du courant de bus CC lorsqu'une défaillance est détectée.

5. Système d'alimentation CC selon l'une quelconque des revendications précédentes, dans lequel une pluralité de condensateurs CC (214 ; 264) sont connectés entre le rail positif et le rail négatif du bus CC commun (200 ; 250).

6. Système d'alimentation CC selon l'une quelconque des revendications précédentes, comprenant en outre une pluralité de charges (236), étant facultativement un équipement marin ou sous-marin, connectées entre le rail positif et le rail négatif du bus CC commun (200; 250).

7. Système d'alimentation CC selon l'une quelconque des revendications précédentes, dans lequel le bus CC commun (200; 250) inclut en outre un rail de terre (260), et dans lequel une pluralité de condensateurs CC (214 ; 264) sont connectés entre le rail de terre et le rail positif ou entre le rail de terre et le rail négatif du bus CC commun (200; 250).

8. Système d'alimentation CC selon la revendication 7, comprenant en outre une pluralité de charges (236), étant facultativement un équipement marin ou sous-marin, connectées entre le rail de terre et le rail positif ou entre le rail de terre et le rail négatif du bus CC commun (200; 250).

9. Procédé d'alimentation en courant continu (DC) à partir d'une ou plusieurs sources d'énergie d'une ou plusieurs charges en utilisant un système d'alimentation CC comprenant un bus CC commun (200; 250) présentant au moins un rail positif (208 ; 258) et au moins un rail négatif (212 ; 262), dans lequel le bus CC commun (200; 250) comprend :
deux sous-sections de bus CC (202, 204 ; 252, 254) ; et
au moins un séparateur de bus CC (206 ; 266, 268) couplé entre les deux sous-sections de bus CC (202, 204 ; 252, 254) ;
dans lequel chaque séparateur de bus CC (206 ; 266, 268) comprend :
au moins un commutateur pouvant être commandé de rail positif (216 ; 270, 278) connecté en série à un inducteur de rail positif (222), l'au moins un commutateur pouvant être commandé de rail positif connecté en série (216 ; 270, 278) et l'inducteur de rail positif (222) fournissant un trajet de courant positif entre les deux sous-sections de bus CC (202, 204 ; 252, 254) pendant le fonctionnement normal du système d'alimentation CC;
une diode de rail positif (220) connectée en parallèle à l'inducteur de rail positif (222), la diode de rail positif (220) présentant une direction de conduction opposée à la direction de conduction de l'au moins un commutateur pouvant être commandé de rail positif (216 ; 270, 278) et fournissant un trajet de courant de circulation ;
au moins un commutateur pouvant être commandé de rail négatif (218 ; 272, 280) connecté en série à un inducteur de rail négatif (226), l'au moins un commutateur pouvant être commandé de rail négatif connecté en série (218 ; 272, 280) et l'inducteur de rail négatif (226) fournissant un trajet de courant négatif entre les deux sous-sections de bus CC (202, 204 ; 252, 254) pendant le fonctionnement normal du système d'alimentation CC ; et
une diode de rail négatif (224) connectée en parallèle à l'inducteur de rail négatif (226), la diode de rail négatif (224) présentant une direction de conduction opposée à la direction de conduction de l'au moins un commutateur pouvant être commandé de rail négatif (218 ; 270, 278) et fournissant un trajet de courant de circulation ;
le procédé comprenant les étapes de :
lorsqu'une défaillance sur le rail positif (208 ; 258) est détectée, commande de l'au moins un commutateur pouvant être commandé de rail positif (216 ; 270, 278) devant être éteint afin de couper le trajet de courant positif, dans lequel le trajet de circuit de circulation fourni par la diode de rail positif (220) dissipe un courant d'inducteur dans l'inducteur de rail positif (222) lorsque l'au moins un commutateur pouvant être commandé de rail positif (216 ; 270, 278) est éteint ; et
lorsqu'une défaillance sur le rail négatif (212 ; 262) est détectée, commande de l'au moins un commutateur pouvant être commandé de rail négatif (218 ; 272, 280) devant être éteint afin de couper le trajet de courant négatif, dans lequel le trajet de courant de circulation fourni par la diode de rail négatif (224) dissipe un courant d'inducteur dans l'inducteur de rail négatif (226) lorsque l'au moins un commutateur pouvant être commandé de rail négatif (218 ; 272, 280) est éteint.

10. Procédé selon la revendication 9, dans lequel le bus CC commun (250) est configuré pour un flux de puissance bidirectionnel, et dans lequel le système d'alimentation CC comprend en outre au moins deux séparateurs de bus CC (266, 268) connectés en série de polarité opposée, chaque séparateur de bus CC (266, 268) configuré pour isoler la sous-section de bus CC saine de la sous-section de bus CC défaillante en fonction de la direction du courant de bus CC lorsqu'une défaillance est détectée.

11. Procédé selon la revendication 9 ou la revendication 10, dans lequel le bus CC commun (200 ; 250) inclut en outre un rail de terre (260), et dans lequel une pluralité de condensateurs CC (214 ; 264) est connectée entre le rail positif et le rail négatif ou entre le rail de terre et le rail positif ou entre le rail de terre et le rail négatif du bus CC commun.

12. Procédé selon la revendication 11, dans lequel les une ou plusieurs charges (236) sont connectées entre le rail positif et le rail négatif ou entre le rail positif et le rail de terre ou entre le rail négatif et le rail de terre.

13. Procédé selon l'une quelconque des revendications 9 à 12, dans lequel l'alimentation en courant continu des une ou plusieurs charges (236) comprend l'alimentation en courant continu d'un équipement marin ou sous-marin.

14. Procédé selon l'une quelconque des revendications 9 à 13, dans lequel l'au moins un commutateur pouvant être commandé de rail positif est commandé pour être éteint par un dispositif de commande (147).
